## Europäisches Patentamt

## European Patent Office

## Office européen des brevets

(11) Numéro de publication: **0 264 335**
**B1**

(12) # FASCICULE DE BREVET EUROPEEN

(45) Date de publication du fascicule du brevet:
16.08.90

(51) Int. Cl.⁵: **G02B 6/42**

(21) Numéro de dépôt: 87402313.8

(22) Date de dépôt: 16.10.87

(54) **Module pour le couplage entre un dispositif semiconducteur et une fibre optique, et procédé d'alignement de ce dispositif semiconducteur et de cette fibre.**

(30) Priorité: 17.10.86 FR 8614421

(43) Date de publication de la demande:
20.04.88 Bulletin 88/16

(45) Mention de la délivrance du brevet:
16.08.90 Bulletin 90/33

(84) Etats contractants désignés:
DE GB IT NL

(56) Documents cités:
CA-A- 1 151 277
FR-A- 2 582 413
FR-A- 2 584 827

(73) Titulaire: THOMSON HYBRIDES ET MICROONDES,
173, bld Haussmann, F-75008 Paris(FR)

(72) Inventeur: Tournereau, Alain, THOMSON-CSF
SCPI 19, avenue de Messine, F-75008 Paris(FR)
Inventeur: Dumas, Daniel, THOMSON-CSF
SCPI 19, avenue de Messine, F-75008 Paris(FR)
Inventeur: Richard, Alain, THOMSON-CSF
SCPI 19, avenue de Messine, F-75008 Paris(FR)
Inventeur: Egea, Guy, THOMSON-CSF SCPI 19, avenue
de Messine, F-75008 Paris(FR)

(74) Mandataire: Taboureau, James et al, THOMSON-CSF
SCPI, F-92045 Paris La Défense Cédex 67(FR)

## Description

La présente invention concerne un module optoélectronique, dans lequel une fibre optique est couplée à un dispositif semiconducteur émetteur ou récepteur de lumière ou une autre fibre optique. L'invention porte plus particulièrement sur les moyens et les éléments, incorporés dans le module optoélectronique, qui permettent d'aligner et de maintenir avec une grande précision la fibre optique et le dispositif semiconducteur. Elle concerne également le procédé d'alignement sur un même axe optique.

Le couplage entre une fibre optique et un dispositif semiconducteur émetteur ou récepteur de lumière est bien connu : il est le point de passage obligé dans tout système utilisant des fibres optiques. Chaque liaison optique nécessite un émetteur à l'une de ses extrémités et un récepteur à l'autre extrémité pour assurer la transformation électronique/optique et réciproquement des signaux d'information à traiter. Il est bien connu également que, en raison des dimensions infimes des surfaces actives des semiconducteurs émetteur ou récepteur et du coeur des fibres optiques, le couplage de ces composants nécessite un alignement précis.

Quelle que soit la structure des modules optiques existants, cet alignement se fait le plus souvent de manière dynamique - c'est-à-dire l'émetteur et le récepteur étant en fonctionnement, le récepteur analysant la lumière transmise par la fibre optique - et la fixation des deux composants se fait par différents moyens : soit par une goutte de colle, polymérisée par un rayonnement ultra-violet ou thermique, soit par refusion de métal. Le collage est irréversible, tandis que la soudure peut être refondue, s'il est nécessaire de réajuster l'alignement. Mais dans les deux cas, il est nécessaire d'apporter une énergie extérieure, thermique ou lumineuse.

L'inconvénient de cet apport d'énergie extérieur est qu'il n'est pas suffisamment localisé. Ainsi certains éléments du module opto électronique tels que la pastille du laser, son support et la colle ou la soudure qui fixent la fibre optique, sont également chauffés. Or les matériaux qui constituent ces parties sont de natures différentes, ils ont des coefficients de dilatation différents, et l'alignement optique, lorsque le module optique est refroidi, n'est plus celui qu'il était à chaud pendant le réglage. En outre, les diodes lasers ou électroluminescentes dégagent de la chaleur, et on les refroidit en fonctionnement au moyen d'un module à effet Peltier, dont l'effet est contrarié par l'apport extérieur d'énergie.

Le module optique selon l'invention permet d'éviter ces inconvénients et rend le réglage et l'alignement optique très simple, répétitibleet démontable. Il est formé sur une plaquette de céramique qui lui sert de substrat pour le positionnement mécanique des composants, en même temps que de circuit hybride pour les liaisons électriques. En outre, cette plaquette est un plan de référence pour l'alignement optique du laser et de la fibre. Une première zone du substrat est dédiée au dispositif semiconducteur, laser, diode électroluminescente ou photodiode, ainsi qu'à la diode de régulation électrique, qui mesure la lumière émise par la face arrière du laser, et à la thermistance de régulation thermique. Une seconde zone du substrat est dédiée à la fixation de la fibre optique, au moyen d'un point de soudure tendre. Sur cette seconde zone - et bien entendu dans l'alignement du faisceau émis par le laser -est sérigraphiée une petite résistance chauffante, avec ses plages de connexions. La résistance est comprise entre deux couches de diélectrique, surmontées d'une métallisation dont l'épaisseur est appropriée pour que l'alignement optique laser-fibre soit presque obtenu. Une préforme de soudure tendre, déposée sur la couche supérieure est fondue par la chaleur dégagée par la résistance chauffante : il suffit de déplacer la fibre dans la goutte de soudure fondue pour aligner la fibre sur le faisceau laser, et de couper le courant qui traverse la résistance pour figer la position de la fibre. La soudure tendre, métallique, peut être remplacée par un produit organique, tel qu'un polymère, qui se ramollit sous l'action de la chaleur. Enfin, la zone du substrat dédiée au laser et celle dédiée à la fibre sont séparées par une barrière thermique qui s'étend entre elles : cette barrière est constituée par une fente dans la plaquette de céramique, et elle minimise la diffusion de la chaleur en direction du laser.

De façon plus précise, l'invention concerne un module pour le couplage d'un dispositif semiconducteur émetteur ou récepteur de lumière et une fibre optique, caractérisé en ce que ses composants sont assemblés sur un substrat céramique formant plan de référence pour l'alignement optique de la fibre par rapport au dispositif semiconducteur, et en ce que le substrat comporte une première zone dédiée au dispositif semiconducteur, et une deuxième zone dédiée à la fibre optique, la deuxième zone supportant une résistance électrique chauffante et étant séparée de la première zone par une barrière thermique constituée par une fente dans le substrat, qui entoure partiellement la résistance.

Les détails et les avantages de l'invention apparaîtront mieux par la description qui suit d'un exemple de réalisation, s'appuyant sur les figures jointes en annexe qui représentent :

- la figure 1, une coupe d'un module optoélectronique selon l'art connu ;
- la figure 2 une vue en coupe d'un module optoélectronique selon l'invention ;
- la figure 3 une vue en coupe agrandie de la région du couplage entre dispositif semiconducteur et fibre optique selon l'invention ;
- la figure 4 une vue en plan, correspondant à la figure 3 ;
- la figure 5 une vue en plan du substrat de la tête de couplage selon l'invention.

De façon à être plus claire et plus précise, l'invention sera exposée en s'appuyant sur le cas d'un module pour le couplage entre un laser et une fibre optique, mais elle concerne de façon plus générale le couplage entre un dispositif semiconducteur optoélectronique et une fibre optique.

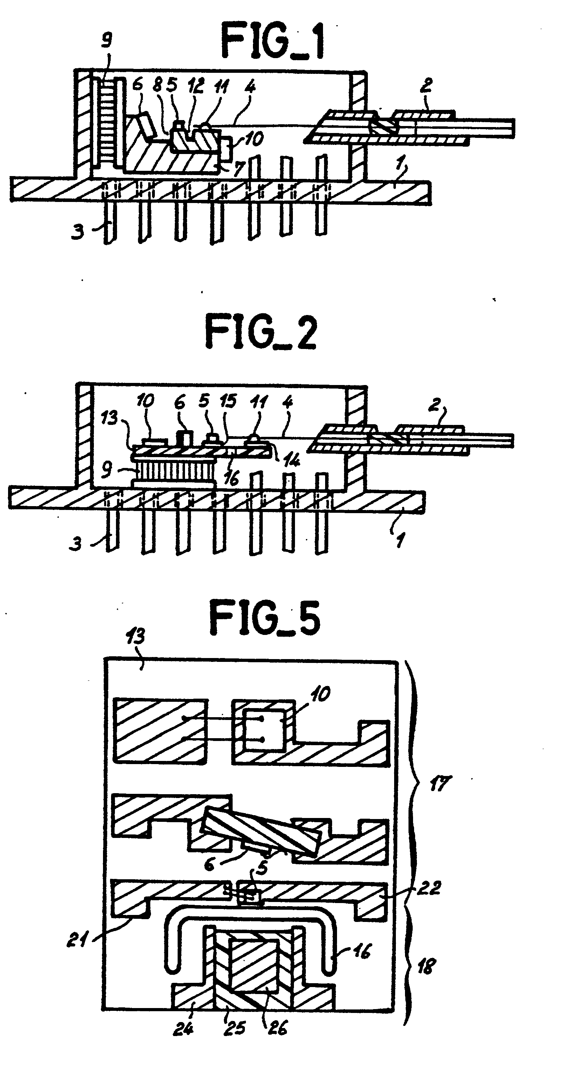

La figure 1 représente un module dont le couplage entre un laser et une fibre optique est d'un modèle connu et actuellement commercialisée. Sa structure est en partie liée aux moyens actuels d'alignement optique. Elle est formée à l'intérieur d'un boîtier métallique 1, muni d'un canon 2, pour le passage de la fibre optique, et d'une pluralité de connexions d'accès 3, dont quelques unes sont esquissées. Les connexions d'accès 3 sont soit dans le fond du boîtier, comme représenté, soit sur deux faces latérales.

La fibre optique 4 est alignée avec le laser 5 et une diode 6 de contre réaction mesure la lumière émise par la face arrière du laser 5. Cette diode 6 est inclinée pour éviter les réflexions lumineuses en direction du laser. L'ensemble de ces pièces sont supportées par deux blocs métalliques 7 et 8, usinés en conséquence et fixés sur un petit module Peltier 9 qui pompe la chaleur sur le bloc 7 et la restitue au boîtier 1 : c'est pourquoi les blocs 7 et 8 sont montés en porte à faux, sans contact avec le boîtier 1. Une ːːermistance 10 assure la régulation thermique par l'élément 9.

Pour aligner la fibre 4 sur le laser 5, celui-ci étant en fonctionnement, une goutte de soudure fondue 11 est déposée sur la fibre 4 et sur la face correspondante du bloc métallique 8. Maintenir la soudure fondue nécessite un apport d'énergie permanent pendant le réglage, et cette énergie échauffe le bloc métallique 8 et le laser 5.

Bien entendu, et si nécessaire, le laser 5, la diode 6, l'élément Peltier 9 et la thermistance 10 peuvent être isolés électriquement entre eux par des couches diélectriques sur les faces appropriées des blocs métalliques 7 et 8.

Sur la figure 2, qui représente un module optoélectronique selon l'invention, les mêmes indices de repère sont conservés lorsqu'ils identifient les mêmes objets.

Selon l'invention, les constituants d'un module optoélectronique sont intégrés sur un substrat 13, qui est une plaquette plane en céramique telle que l'alumine, fixée sur un élément Peltier 9 lui-même fixé à plat sur le fond du boîtier 1 du module optoélectronique. Le substrat 13 est, selon sa dimension parallèle à l'axe de la fibre optique, plus grand que l'élément Peltier 9, de sorte qu'il comprend deux zones.

La première zone, dédiée au laser, est à l'aplomb de l'élément Peltier 9. Elle supporte le laser 5, la diode de régulation électrique 6 et la thermistance 10 de régulation thermique, ainsi que les pistes conductrices sérigraphiées d'accès électrique à ces trois composants. La diode de régulation 6 est fixée verticalement par rapport au substrat 13, sur une plaquette céramique métallisée en conséquence, et désaxée latéralement pour éviter les réflexions parasites vers le laser 5. La première zone du substrat est régulée en température.

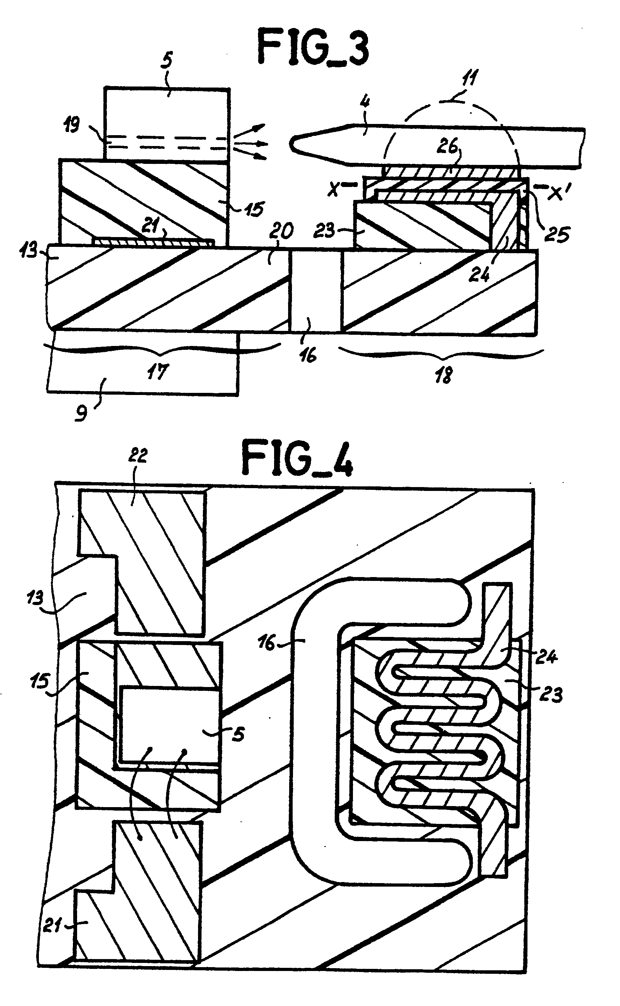

La deuxième zone du substrat, dédiée à la fibre optique 4, est en porte à faux hors de l'élément Peltier 9, et n'est pas régulée en température. Elle supporte un sandwich 14 de couches, qui seront détaillées en figures 3 et 4, dont une couche résistive chauffante, et le point de soudure 11 maintenant la fibre optique 4. L'épaisseur totale des couches 14 est ajustée simultanément à l'épaisseur d'un support 15 sous le laser de telle sorte que l'axe optique du laser 5 et l'axe optique de la fibre 4 soient déjà, avant le réglage, grossièrement alignés, c'est-à-dire à environ 5 ou 6 microns près - un alignement optique se fait à ± 1 micron -. Lorsqu'un courant électrique traverse la résistance chauffante, cette deuxième zone du substrat s'échauffe par conduction puisqu'elle n'est pas régulée par l'élément Peltier 9 : une barrière thermique 16, constituée par une fente pratiquée dans l'épaisseur du substrat 13, détourne et minimise le flux thermique provenant de la résistance chauffante, vers le laser 5.

Les figures 3 et 4 qui constituent des agrandissements de la région de couplage entre fibre et laser, permettent de mieux voir la structure selon l'invention. La partie droite de la figure 4 est coupée au niveau du plan XX' de la figure 3, de façon à laisser voir la résistance chauffante.

Le substrat céramique 13 comprend donc une zone 17, régulée en température et dédiée au laser 5, et une zone 18, non régulée et dédiée à la fibre 4, ces deux zones étant délimitées par une fente 16 dans le substrat 13.

Dans la première zone 17, le laser 5 est fixé sur un socle 15, qui peut être formé par sérigraphie de couches diélectriques et conductrice. On a symbolisé en pointillés le ruban émetteur 19 du laser 5 : ce ruban émetteur est à proximité de l'une des faces principales de la pastille du laser 5. La sérigraphie et la fabrication des lasers sont assez bien maîtrisées pour que la distance séparant le ruban émetteur 19 du plan de référence 20 constitué par la face supérieure du substrat 13 soit connue à environ ± 5 microns près. On sait également déposer des métallisations 21 et 22 de prise de contacts sur le laser, dont l'une au moins, 22, franchit la marche constituée par la couche du socle 15.

Dans la deuxième zone 18, et sur un axe approprié, est déposé le sandwich de couches sérigraphiées 14. Celui-ci est composé de :
- une couche isolante intermédiaire 23, en matériau diélectrique. Son objectif est double : isoler thermiquement le substrat 13, lorsque la résistance chauffe, et compenser en partie l'épaisseur du socle 15 du laser 5.
- une résistance électrique 24, avec ses plages de connexions qui descendent sur le substrat 13. Cette résistance a une valeur de l'ordre de $10\Omega$ ±25%, dépendant évidemment de la tension sous laquelle elle est alimentée.
- une couche isolante 25, qui recouvre soigneusement toute la résistance 24. L'objet de cette couche 25, en matériau diélectrique, est d'éviter que la préforme de soudure que l'on posera ensuite sur le sandwich 14, pour fixer la fibre 4, ne court-circuite la résistance 24.
- une couche métallique 26, qui permet à la soudure 11 de mouiller la surface sur laquelle elle adhère, et de délimiter cette surface. La couche 26 transmet également à la soudure la chaleur dégagée par la résistance chauffante.

L'épaisseur de la couche isolante 23 est telle que l'épaisseur totale du sandwich 14 permet à la fibre optique 4 d'être déjà, avant réglage, approximativement alignée avec le ruban émetteur 19 du laser, à ± .5 microns près.

La barrière thermique entre les deux zones 17 et 18 du substrat 13 est formée par une fente 16, percée au laser de puissance à travers toute l'épaisseur du substrat. Cette fente 16 peut avoir une forme différente que celle qui est représentée, mais elle est soumise à deux impératifs.

- elle ne doit pas détruire l'unicité du substrat 13, qui reste donc en un seul morceau, et constitue le plan de référence pour l'alignement laser-fibre. Le substrat, malgré la fente 16, reste monolithique : la fente n'atteint donc pas les bords du substrat.

- du point de vue de la dissipation thermique vers le substrat, elle est avantageusement tracée au plus près du sandwich 14, qu'elle entoure partiellement - mais le plus près possible sans mettre en cause la solidité du substrat - sur trois faces.

La figure 5 représente une vue en plan du substrat 13 qui supporte les différents composants décrits pour faire un module optoélectronique, ce substrat étant caractérisé par la présence d'une résistance chauffante 24 et d'une fente 16, barrière thermique.

Le procédé d'alignement selon l'invention est très simple. Une préforme - rondelle ou carré - de soudure est déposée sur la couche conductrice 26, et la fibre optique 4 posée sur la préforme. La tête optique est alors mise en fonctionnement et, en même temps, un courant - quelques 25 mA sous 5V - est envoyé à travers la résistance chauffante 24. La préforme de soudure fond, prend une forme hémisphérique et la fibre optique peut pénétrer dans cette masse de soudure en fusion.

Un appareil de micromanipulation permet de déplacer la fibre optique selon trois dimensions dans l'espace, jusqu'à ce que l'alignement optimum soit obtenu. Il suffit alors de couper l'alimentation électrique sur la résistance chauffante 24 pour qu'en quelques secondes la goutte de soudure 11 soit figée.

Le procédé permet de reprendre cet alignement, en faisant à nouveau fondre la soudure si, au cours du refroidissement, le jeu des coefficients de dilatation des composants de la tête optique a légèrement modifié l'alignement.

Les résultats obtenus sont meilleurs si la fibre optique est préalablement métallisée sur sa partie qui traverse la goutte de soudure.

Selon l'invention, le moyen de fixation de la fibre optique peut être également, à la place de la soudure métallique, un petit volume d'un produit organique tel qu'un polymère ou une goutte de colle, solide à froid mais fusible à chaud.

La fibre est ensuite immobilisée dans le canon 2 du boîtier 1 par sa gaîne plastique et au moyen d'une goutte de colle ou par soudure et le boîtier est fermé par un couvercle.

Bien entendu, le module pour le couplage et le procédé selon l'invention sont applicables à tout dispositif regroupant semiconducteur émetteur ou récepteur de lumière et une fibre optique.

**Revendications**

1. Module pour le couplage entre un dispositif semiconducteur (5) émetteur ou récepteur de lumière et une fibre optique (4), caractérisé en ce que ses composants (4, 5) sont assemblés sur un substrat céramique (13) formant plan de référence pour l'alignement optique de la fibre (4) par rapport au dispositif semiconducteur (5), et en ce que le substrat (13) comporte une première zone (17), dédiée au dispositif semiconducteur (5), et une deuxième zone (18), dédiée à la fibre optique (4), la deuxième zone (18) supportant une résistance électrique chauffante (24) et étant séparée de la première zone (17) par une barrière thermique constituée par une fente (16) dans le substrat (13), qui entoure partiellement la résistance (24).

2. Module pour le couplage selon la revendication 1, caractérisé en ce que le dispositif semiconducteur (5) émetteur de lumière est un laser.

3. Module pour le couplage selon la revendication 1, caractérisé en ce que le dispositif semiconducteur (5) émetteur ou récepteur de lumière est une diode électroluminescente.

4. Module pour le couplage selon la revendication 1, caractérisé en ce que la résistance électrique chauffante (24) est une résistance sérigraphiée, comprise entre une première couche isolante (23) sérigraphiée, en matériau diélectrique, déposée sur la deuxième zone (18) du substrat (13), et une deuxième couche isolante (25) sérigraphiée, en matériau diélectrique, elle-même recouverte par une couche conductrice (26) sérigraphiée métallique.

5. Module pour le couplage selon la revendication 4, caractérisé en ce que l'ensemble des couches sérigraphiées (23, 24, 25, 26) est positionné sur le substrat (13) au lieu où doit être fixée la fibre optique (4) par un point de soudure (11).

6. Module pour le couplage selon la revendication 4, caractérisé en ce que, le dispositif semiconducteur (5) étant fixé sur un socle (15), les épaisseurs des couches sérigraphiées (23 à 26) sur la deuxième zone du substrat (18) et l'épaisseur du socle (15) sur la première zone du substrat (17) sont ajustées pour que les axes optiques du dispositif semiconducteur (5) et de la fibre optique (4) soient avant réglage alignés à environ 5 microns près.

7. Module de couplage selon la revendication 1, caractérisé en ce que, en vue de limiter le transfert thermique par le substrat (13), la fente (16), qui traverse le substrat (13) sur toute son épaisseur, est tracée au plus près de la résistance chauffante (24).

8. Module de couplage selon la revendication 7, caractérisé en ce que la fente (16) de barrière thermique a une forme enveloppante autour de la résistance chauffante (24) mais n'atteint aucun côté du substrat (13), lui conservant sa rigidité de plan de référence.

9. Procédé d'alignement entre une fibre optique (4) et un dispositif semiconducteur (5) émetteur ou récepteur de lumière dans une tête de couplage selon l'une quelconque des revendications 1 à 9, par réglage dynamique, la tête optique étant en fonctionnement, caractérisé par la suite d'opérations suivantes :

- un petit volume d'un moyen de fixation (11) fusible, est déposé sur la couche conductrice (26) qui est au-dessus de la résistance chauffante (24),

- une fibre optique (4) est déposée sur le moyen de fixation (11),
- un courant électrique est appliqué sur la résistance chauffante (24), et le moyen de fixation en fondant, prend une forme de goutte dans laquelle pénètre la fibre (4),
- la fibre (4) est alignée par micromanipulation,
-lorsque l'alignement optique est obtenu, le courant qui traverse la résistance chauffante (24) est interrompu et la fibre (4) immobilisée par refroidissement du moyen de fixation.

10. Procédé d'alignement selon la revendication 9, caractérisé en ce que le moyen de fixation (11) est un alliage de soudure métallique.

11. Procédé d'alignement selon la revendication 9, caractérisé en ce que le moyen de fixation (11) est un polymère organique, solide à froid et fusible à chaud.

## Patentansprüche

1. Modul zur Kopplung eines Halbleiterbauelementes (5) zum Aussenden oder Empfangen von Licht mit einer optischen Faser (4), dadurch gekennzeichnet, daß dessen Bauteile (4, 5) auf einem Keramiksubstrat (13), das eine Bezugsebene zur optischen Ausrichtung der Faser (4) in bezug auf das Halbleiterbauelement (5) bildet, angeordnet sind und daß das Substrat (13) eine auf das Halbleiterbauelement (5) zugeschnittene erste Zone (17) und eine auf die optische Faser (4) zugeschnittene zweite Zone umfaßt, wobei die zweite Zone (18) einen elektrischen Heizwiderstand (24) trägt und von der ersten Zone (17) durch eine thermische Sperre getrennt ist, die durch einen den Widerstand (24) teilweise umgebenden Spalt (16) im Substrat (13) gebildet wird.

2. Modul zur Kopplung gemäß Anspruch 1, dadurch gekennzeichnet, daß das Halbleiterbauelement (5) zum Aussenden von Licht ein Laser ist.

3. Modul zur Kopplung gemäß Anspruch 1, dadurch gekennzeichnet, daß das Halbleiterbauelement (5) zum Aussenden und Empfangen von Licht eine Elektrolumineszenz-Diode ist.

4. Modul zur Kopplung gemäß Anspruch 1, dadurch gekennzeichnet, daß der elektrische Heizwiderstand (24) ein Siebdruckwiderstand ist, der zwischen einer ersten Siebdruckisolierschicht (13) aus dielektrischem Material, die in der zweiten Zone (18) des Substrats (13) angeordnet ist, und einer zweiten Siebdruckisolierschicht (15) aus dielektrischem Material, die selbst von einer leitenden, metallischen Siebdruckschicht (26) überzogen ist, eingeschlossen ist.

5. Modul zur Kopplung gemäß Anspruch 4, dadurch gekennzeichnet, daß die Gesamtanordnung der Siebdruckschichten (23, 24, 25, 26) auf dem Substrat (13) an der Stelle positioniert ist, an der die optische Faser (4) mittels eines Lötpunkts (11) befestigt werden muß.

6. Modul zur Kopplung gemäß Anspruch 4, dadurch gekennzeichnet, daß das Halbleiterbauelement (5) auf einem Sockel (15) befestigt ist, daß die Dicken der Siebdruckschichten (23 bis 26) auf der zweiten Zone des Substrats (18) und die Dicke des Sockels (15) auf der ersten Zone des Substrats (17) so abgestimmt sind, daß sich die optischen Achsen des Halbleiterbauelements (5) und der optischen Faser (4) vor der Ausrichtregelung in einem Abstand von ungefähr 5 μm befinden.

7. Modul zur Kopplung gemäß Anspruch 1, dadurch gekennzeichnet, daß zur Begrenzung der Wärmeübertragung durch das Substrat (13) der Spalt (16), der das Substrat (13) in dessen ganzer Dicke durchzieht, ganz nahe am Heizwiderstand (24) geführt wird.

8. Modul zur Kopplung gemäß Anspruch 7, dadurch gekennzeichnet, daß der als Wärmebarriere dienende Spalt (16) eine den Heizwiderstand (24) umgebende Gestalt besitzt, aber keinen Rand des Substrats (13) erreicht, wodurch die Steifigkeit der Bezugsebene des Substrats (13) erhalten bleibt.

9. Verfahren zur Ausrichtung einer optischen Faser (4) gegenüber einem Halbleiterbauelement (5) zur Aussendung oder zum Empfang von Licht in einem Kopplungskopf gemäß einem der Ansprüche 1 bis 8 mittels dynamischer Einstellung, wobei der optische Kopf in Funktion ist, gekennzeichnet durch die Abfolge der folgenden Operationen:
– ein kleines Volumen eines schmelzbaren Befestigungsmittels (11) wird auf der leitenden Schicht (26), die sich über dem Heizwiderstand (24) befindet, angeordnet,
– eine optische Faser (4) wird auf dem Befestigungsmittel (11) angeordnet,
– durch den Heizwiderstand (24) wird ein elektrischer Strom geschickt und das Befestigungsmittel nimmt während des Schmelzens die Gestalt eines Tropfens an, in den die Faser (4) eindringt,
– die Faser (4) wird durch Mikromanipulation ausgerichtet,
– wenn die optische Ausrichtung erreicht ist, wird der den Heizwiderstand (24) durchfließende Strom unterbrochen und die Faser (4) durch Erstarren des Befestigungsmittels unbeweglich gemacht.

10. Ausrichtungsverfahren gemäß Anspruch 9, dadurch gekennzeichnet, daß das Befestigungsmittel (11) eine Legierung eines metallischen Lötmittels ist.

11. Ausrichtungsverfahren gemäß Anspruch 9, dadurch gekennzeichnet, daß das Befestigungsmittel (11) ein organisches Polymer ist, das erkaltet fest und erhitzt schmelzbar ist.

## Claims

1. A module for coupling a light emitting or light receiving semiconductor (5) with an optical fiber (4), characterized in that the components (4 and 5) thereof are assembled on a ceramic substrate (13) forming a reference plane for the optical alignment of the fiber (4) in relation to the semiconductor device (5), and in that the substrate (13) comprises a first zone (17), provided for the semiconductor device (5) and a second zone (18), provided for the optical fiber (4), the second zone (18) bearing an electrical heating resistor (24) and being separated from the first zone (17) by a thermal barrier in the form of a gap (16) in the substrate (13) which partially surrounds the resistor (24).

2. The coupling module as claimed in claim 1, characterized in that the light emitting semiconductor device (5) is a laser.

3. The module as claimed in claim 1, characterized in that the light emitting or receiving semiconductor device (5) is an electroluminescent diode.

4. The coupling module as claimed in claim 1, characterized in that the electrical heating resistor (24) is a screen printed resistor, comprised between a first screen printed insulating layer (23), of dielectric material, placed on the second zone (18) of the substrate (13) and a second screen printed insulating zone (25) of dielectric material and itself covered by a metallic screen printed conducting layer (26).

5. The coupling module as claimed in claim 4, characterized in that the arrangement of the screen printed layers (23, 24, 25 and 26) is positioned on the substrate (13) at a location where the optical fiber (4) is to be affixed by a soldered joint (11).

6. The coupling module as claimed in claim 4, characterized in that the semiconductor device (5) is secured on a base (15) and the thicknesses of the screen printed layers (23 through 26) on the second zone of the substrate (18) and the thickness of the base (15) on the first zone of the substrate (17) are adjusted so that the optic axes of the semiconductor device (5) and of the optical fiber (4) are, before regulation, aligned to within about 5 microns.

7. The coupling module as claimed in claim 1, characterized in that with a view to limiting thermal transfer via the substrate (13) the gap (16), which extends through the substrate (13) for the entire thickness thereof, is drawn very close to the heating resistor (24).

8. The coupling module as claimed in claim 7, characterized in that the gap (16) of the thermal barrier has an enveloping form around the heating resistor (24) without reaching any side of the substrate (13) so as to maintain its plane of reference rigidity.

9. A method of producing alignment between an optical fiber (4) and a light emitting or light receiving semiconductor device (5) in a coupling head as claimed in any one of the preceding claims 1 through 9, by dynamic regulation with the optical head in operation, characterized by the sequence of the following operations

— a small volume of fusible fixing material (11) is placed on the conducting layer (26) which is over the heating resistor (24),

— an optical fiber (4) is placed on the fixing material (11),

— an electric current is supplied to the heating resistor (24), and as it fuses the fixing material assumes the form of a droplet into which the fiber (4) penetrates,

— the fiber (4) is aligned by micromanipulation, and when optical alignment has been performed, the current through heating resistor (24) is interrupted and the fiber (4) is secured in place by cooling the fixing material.

10. The method of producing alignment as claimed in claim 9, characterized in that the fixing material (11) is a metallic soldering alloy.

11. The method of producing alignment as claimed in claim 9, characterized in that the fixing material (11) is an organic polymer which is solid when cold and is fused when heated.

# FIG_1

# FIG_2

# FIG_5

# FIG_3

# FIG_4